# EUROPEAN PATENT SPECIFICATION

(11) **EP 1 550 109 B1**
(45) Date of publication and mention of the grant of the patent: **14.02.2007**
(21) Application number: 03798985.2
(22) Date of filing: 12.09.2003
(51) Int. Cl.: G11B 5/00, G11B 5/48, G11B 5/49, G11B 5/74, G11C 11/15, G11C 11/16

(54) **STORAGE SYSTEM USING ELECTROMAGNETIC ARRAY**
SPEICHERSYSTEM MIT EINEM ELEKTROMAGNETISCHEN ARRAY
SYSTEME MEMOIRE UTILISANT UN RESEAU ELECTROMAGNETIQUE

(30) Priority: 03.10.2002 EP 02079079
(43) Date of publication of application: 06.07.2005
(73) Proprietor: Koninklijke Philips Electronics N.V., 5621 BA Eindhoven (NL)
(72) Inventor: LENSSEN, Kars-Michiel, H., NL-5656 AA Eindhoven (NL); VAN HOUTEN, Hendrik, NL-5656 AA Eindhoven (NL)
(74) Representative: van Oudheusden-Perset, Laure E.
(86) International application number: PCT/IB2003/004007
(87) International publication number: WO 2004/032115

(56) References cited:
- EP-A- 1 130 578
- US-A- 4 636 893
- US-A- 5 592 413
- US-A- 5 956 216

## Description

The invention relates to a storage system comprising a record carrier and a storage device, the record carrier having an information plane that is provided with an electro-magnetic material constituting a two dimensional array of bit locations, a magnetic state of said material at a bit location representing the value thereof, and the storage device having an interface surface for cooperating with the information plane, which interface surface is provided with a two-dimensional array of electro-magnetic elements that are sensitive to said magnetic state of the electro-magnetic material, which record carrier can be coupled to and removed from the storage device.

The invention further relates to a record carrier comprising an information plane on a substrate that is provided with a layer of an electro-magnetic material constituting an array of bit locations, a magnetic state of said material at a bit location representing the value thereof.

The invention further relates to a storage device.

A storage system, record carrier, and a device for storing information are known from patent US 5,956,216. Data storage systems using magnetic material on a disc-type record carrier are well known, for example a removable type magnetic record carrier like the floppy disk. The document describes a magnetic record carrier of a patterned type. The record carrier has an information plane that is provided with a magnetic layer that can be magnetized by a suitable magnetic field from a write head. In particular the information plane is provided with a non-magnetic substrate and magnetic domain elements that can have two magnetization values. The magnetic domain elements constitute bit locations for storing a single bit of data. The device has a head and a write unit for recording information in a track constituted by the bit locations on the record carrier. The value of a bit location must be set or retrieved by positioning a read/write head opposite the bit location, e.g. by scanning the track. A problem of the known magnetic storage system is that the scanning does not allow immediate random access to any bit location. The process of positioning the head via a jump to a required part of the track is time consuming.

EP 1,130,578 reflecting the preamble of claim 1, discloses a storage system providing magnetic storage bits. A two-dimensional array of cantilever tips used in the storage system, each of which tips serves as a heat source and for reading the magnetic field. Bits can be generated with or without direct contact between tip and storage medium. This document does not disclose the positioning of the array of cantilever tips to the array of storage bits.

Therefore it is an object of the invention to provide a system comprising a record carrier and a device for storing information that allows fast access to the bit locations.

According to a first aspect of the invention the object is achieved with a storage system as defined in the opening paragraph, the storage device being defined by the subject matter of claim 1

According to a second aspect of the invention the object is achieved with a record carrier as defined in the opening paragraph, the record carrier being defined by the subject matter of claim 2.

According to a third aspect of the invention the object is achieved with a device as defined in the opening paragraph, the device-being defined by the subject matter of claim 7.

The effect of the array constituted by electro-magnetic elements cooperating with the information plane is that data from a large number of bit locations can be retrieved simultaneously via electro-magnetic interaction. This has the advantage that data can be accessed at a high speed. In particular the alignment is different from a scanning system in that the array is aligned to the bit locations parallel to the information plane and also in height with respect to the information plane. Compared to scanning magnetic hard-disk systems the advantage is that no high scanning speed between a head and the disk is needed, which prevents fatal head-disk interactions like a head-crash.

The invention is also based on the following recognition. The magnetic hard-disk storage system provides a non-removable record carrier that can be recorded by magnetizing material in a layer or pattern in a user device. However removable magnetic discs like floppy discs are slow and large, and require a scanning mechanism which is sensitive to mechanical shocks. The inventors have seen that data on a record carrier can be accessed fast and reliably by bringing the surface of the information plane into close vicinity of an array of electro-magnetic elements. The elements can detect a magnetic state within a predefined near-field working distance, which is in practice in the same order of magnitude as the minimum dimensions of the bit location. Alignment is required to bring the elements opposite and close to the bit locations within the near-field working distance. Suitable read/write elements can be produced using solid state production methods, e.g. known from producing MRAM magnetic storage devices.

In an embodiment of the record carrier the substrate is of a flexible material for allowing positioning of the bit locations near the electro-magnetic elements within the near-field working distance between a bit location and the corresponding electro-magnetic element. A rigid substrate requires a highly level plane. The flexible material has the advantage that close contact between the bit locations and the electro-magnetic elements is easily achieved by applying pressure on the flexible material.

Further preferred embodiments of the record carrier and storage device according to the invention are given in the dependent claims.

These and other aspects of the invention will be apparent from and elucidated further with reference to the embodiments described by way of example in the following description and with reference to the accompanying drawings, in which
Figure 1 shows an information carrier part (top view),
Figure 2 shows an information carrier part and electro-magnetic elements,
Figure 3 shows a read-out part,
Figure 4a shows a storage device (top view) and record carrier,
Figure 4b shows a storage device (side view) and record carrier,
Figure 4c shows a record carrier in a cartridge,
Figure 5 shows an array of electro-magnetic elements,
Figure 6 shows a sensor element in read mode, and
Figure 7 shows a read/write element in write mode.

In the Figures, elements which correspond to elements already described have the same reference numerals.

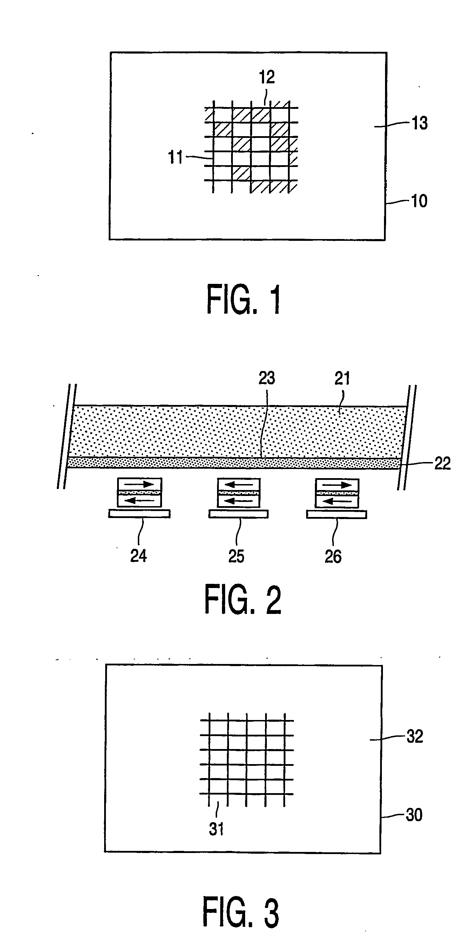

Figure 1 shows an information carrier part (top view). An information carrier part 10 has an information plane that is provided with a magnetic material 12 constituting an array of bit locations 11. The magnetic state of the material 12 at the information plane provides a physical parameter for representing a value of a bit location. It is noted that the information plane is situated on a top surface 13 of the information carrier part 10. The top surface 13 of the information carrier part is intended to be coupled to an interface surface of a read-out part. The information plane is considered to be present at an effective distance from the mechanical top layer, e.g. a thin cover layer for protecting the information plane may constitute the outer layer of the information carrier part. Further it is noted that material away from the top surface 13 and outside a near-field working distance of an intended read-out part is not considered part of the information plane. Electro-magnetic elements in said read-out part are placed near the information plane, but some intermediate material like contamination may be present in between. Hence the effective distance is determined by any intermediate material. The intended read-out elements that have a near-field working distance extending outward from the interface surface towards the information plane. The physical effect of the magnetic state of material at the information plane for reading the information is explained below with reference to Figure 2.

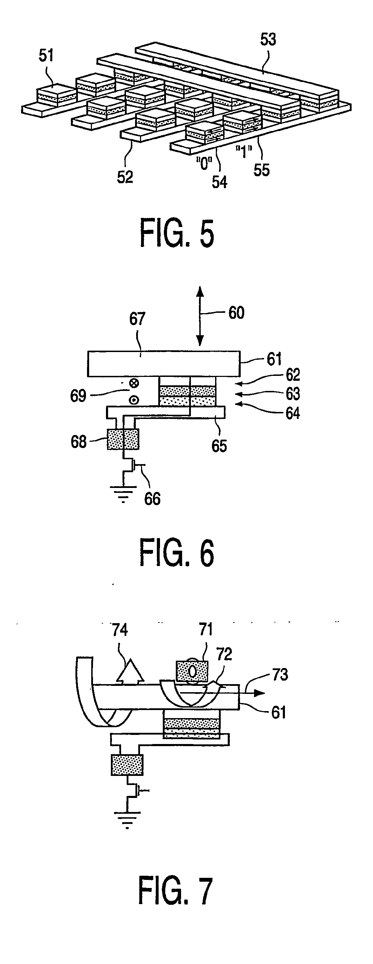

Figure 2 shows an information carrier part and electro-magnetic elements. The information carrier part is constituted by a substrate 21. An information plane is constituted on the top side of the substrate 21 by a layer 22 of magnetic material, areas of the information layer constituting an array of bit locations 23. In a first bit location opposite a first electro-magnetic element 24 the material has a magnetic state for example indicating the logic value 1, in a second bit location opposite a second electro-magnetic element 25 the material has a magnetic state indicating a logic value 0, and in a third bit location opposite a third electro-magnetic element 26 the material has a magnetic state indicating a logic value 1. The electro-magnetic elements 24,25,26 have a multilayer stack for detecting the magnetic state as described in detail with Figure 6. The top layer of the multilayer stack is influenced by the magnetic state of the bit location. The layer 23 of magnetic material can be applied by well known manufacturing methods for magnetic media, and programming may be applied during production for presetting the magnetic states of the bit locations. Suitable manufacturing methods are sputtering or pressing using a mask.

Figure 3 shows a read-out part. The read-out part 30 is intended to cooperate with the information carrier parts described above. Thereto the read-out part has an interface surface 32. The interface surface 32 is provided with an array 31 of electro-magnetic elements. The array is a two-dimensional layout of electro-magnetic sensor units that are sensitive to the magnetic state of the material on a near-field working distance. The array is similar to solid state MRAM arrays of bit cells as described below with reference to Figure 5.

It is noted that other combinations of an electro-magnetic material and a sensor unit can be chosen. In another embodiment the sensor units are arranged for emitting light as the electromagnetic field for affecting the state of the material, e.g. phase-change material known from CD-RW, and detecting the effect of the material on a near-field working distance from the source of light. The further embodiments described below are based on using magnetic material. A suitable material is a hard magnetic material and a suitable electro-magnetic element is based on the magneto-resistive effect. An example is described below with reference to Figures 6 and 7.

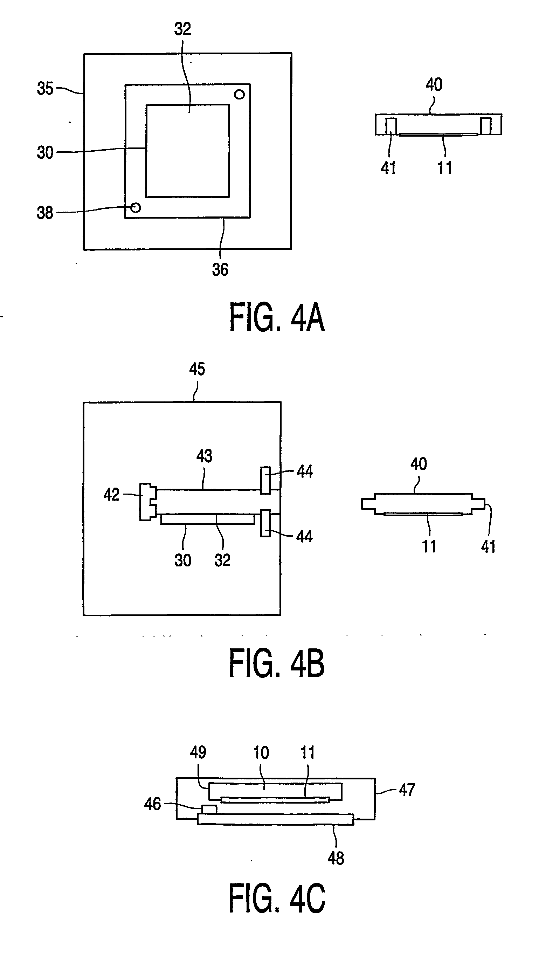

Figure 4a shows a storage device (top view) and record carrier. The storage device has a housing 35 and an opening 36 for receiving a record carrier 40.

The record carrier 40 includes an information carrier part 10 that has an information plane that has an array of bit locations 11 as described above with reference to Figures 1 and 2. Further the record carrier has alignment elements 41 for cooperating with the complementary alignment elements 38 on the device for positioning the bit locations near the electro-magnetic elements within the near-field working distance between a bit location and the corresponding electro-magnetic element during said coupling. Read-out of the record carrier is realized by providing appropriate alignment and registration during insertion of the medium in the reader device as described below. In an embodiment the alignment elements are predefined and precisely shaped parts of the outer walls of the information carrier part. It is noted that the record carrier can be substantially only the information carrier part as described above, or an assembly containing an information carrier part. For example a single substrate carrying the information plane is further shaped to accommodate the several types of alignment elements as described hereafter.

When coupling the record carrier 40 to the storage device 35 the record carrier is placed on the opening 36. The opening 36 is provided with an interface surface 32 on a read-out unit 30 as described above with reference to Figure 3, and with alignment elements 38, for example protruding pins. The alignment elements 38, 41 are arranged for determining the position of the bit locations on the record carrier with respect to the position of the interface surface of the read-out unit 30 in planar directions parallel to the interface surface.

In an embodiment the opening 36 is a recess in the surface of the housing, the recess having precisely shaped walls as alignment elements for cooperating with the outer perimeter of the record carrier 40 for aligning the information carrier part.

In an embodiment the storage device is provided with processing circuitry for analyzing the read-out signals of the electro-magnetic elements for eliminating influences of neighboring bit locations. Any electro-magnetic element may be influenced somewhat by adjacent bit locations, in particular due to some remaining misalignment. However, by analyzing the read-out signals of neighboring electro-magnetic elements and subtracting some of those from the current read-out signal, the detected value of the current bit location is improved. Hence electronic correction of inter-symbol interference is provided. The analysis may be controlled by global information about the remaining misalignment, for example indicating which of the neighboring read-out signals must be subtracted and to which extent.

In the direction perpendicular to the interface surface some pressure is required to make sure that the distance of the bit locations to the electro-magnetic elements in the read-out part is within the near-field working distance. The pressure may be provided by a user just pressing the record carrier to the storage device, or by a resilient lid or cover on top of the record carrier (not shown). Other options for achieving close physical contact are well-known to a skilled man.

In an embodiment of the record carrier the information plane is provided on a flexible substrate. The device is provided with a pressure system for bringing the flexible substrate in close contact with the interface surface, for example by creating a low pressure or vacuum between the substrate and the interface surface. In an embodiment the device is provided with a generator for generating an attracting field for attracting the information carrier to the interface surface. The type of attracting field is different from the field used by the sensor element. For example an electrostatic field is generated for attracting a record carrier of a magnetic type. Alternatively a magnetic field is generated for a record carrier based on capacitive read-out.

In an embodiment the alignment elements 38 on the device are connected to actuators for moving the record carrier with respect to the interface surface 32. Only a small movement, in the order of magnitude of the dimensions of a single bit location (i.e. a few µm), is sufficient to align the electro-magnetic elements with the bit locations. For the actuators several types may be used, e.g. voice coil type, piezo type or electrostatic type. In an embodiment the actuators are controlled by detecting misalignment of the bit locations. The misalignment can be derived from read-out signals of the electro-magnetic elements. For example if there is a substantial misalignment the electro-magnetic elements will cover adjacent bit locations. Read-out signals of adjacent locations having the same value will be different from read-out signals of adjacent locations having differing values. Hence if such differences occur, i.e. if the read signals of some bit locations have values at an intermediate level between the maximum and minimum levels of other bit locations, misalignment is detected. It is noted that in non correlated data the intermediate levels will occur in substantially 50% of the bit locations due to the fact that the respective neighboring location has a same or different logical value. In an embodiment predefined control patterns having known neighboring bits are included for misalignment detection. A control signal is generated to activate the actuators, and after applying the control signal the read-out signal is again analyzed. In an embodiment the record carrier is provided with optical marks for alignment, and the device is provided with separate optical sensors for detecting the optical marks for generating a misalignment signal.

In an embodiment of the storage system the pitch of the array of electro-magnetic elements is larger than the pitch of the array of the bit locations, for example by an integral factor n = 2 in one or both planar dimensions. Some stepwise movement of the information carrier part relative to the read-out part is provided to read-out positions in each direction in which the pitch differs to access every bit location. The movement may be provided as indicated above, e.g. by the actuators. Such scanning over small distances by means of micro-mechanic means can make it possible to use media with a higher bit density than the density of the read-out part.

In an embodiment of the record carrier the information plane is provided with position mark patterns that are unique patterns in the information plane within a predefined area of the information carrier. The storage device is provided with a processor for applying techniques of pattern recognition for detection the absolute position of the position mark patterns with respect to the electro-magnetic elements array by analyzing the signals detected from the electro-magnetic elements. For example the position mark patterns may comprise a large area of material at a predefined magnetic state which is larger than any initial mechanical misalignment. The large area is surrounded by a contour with material having a different state in a predetermined pattern. Hence some electro-magnetic elements will always initially be covered by said large area. By analyzing the surrounding electro-magnetic elements the misalignment can be detected easily.

In an embodiment the array of electro-magnetic elements is substantially smaller than the information plane, e.g. 4 times smaller. The device is provided with actuators that are arranged for positioning the record carrier or the array of electro-magnetic elements at a few, e.g. 4, read-out positions for reading areas of the information plane.

In an embodiment the alignment elements of the record carrier are constituted by oblong protruding guiding bars, and the complementary guiding elements on the device are slots or grooves. The alignment by these elements is effective in one planar dimension. The alignment in the other planar dimension may be provided by a wall or protruding stopping pin on the device. Alternatively there may be no specific stopping position in the second planar dimension, but the information is retrieved from the bit locations while the record carrier is being propelled along that second direction, e.g. by the user pushing the record carrier via a guiding slot. Such constellation is advantageous for one-time reading of data from the record carrier, e.g. in an application like a personal passport carrying biomedical or DNA information for access control at an airport.

Figure 4b shows a storage device (side view) and record carrier. The storage device has a housing 45 and an opening 43 for receiving a record carrier 40. When coupling the record carrier 40 to the storage device 45 the record carrier is placed on the opening 43. Close contact between the two parts is obtained by pressing (possibly with contact liquid) the read-out array against the information carrier when the slot of the reader is closed. The opening 43 is provided with an interface surface 32 on a read-out unit 30 as described above with reference to Figure 3, and with alignment elements 42 at the inner end of the opening and outer alignment elements 44 at the entry side of the opening 43. The outer alignment elements 44 are arranged for clamping the record carrier. The record carrier has a protruding alignment element 41 for cooperating with the clamping outer alignment elements 44 on the device for positioning the bit locations near the electro-magnetic elements within the near-field working distance between a bit location and the corresponding electro-magnetic element during said coupling. The clamping movement may be activated by the force the user applies during entering the record carrier into the opening, or by an actuator.

Figure 4c shows a record carrier in a cartridge. The record carrier has a cartridge 47 enclosing the information carrier part 10. The cartridge 47 has a movable cover 48 that effectively seals off the information plane from contamination (dust and fingerprints) when the record carrier is not coupled to a storage device. A storage device has an opening mechanism (not shown) for moving the cover aside during said coupling. Several options for slidable covers are known from optical or magnetical recording disc cartridges and cooperating devices.

In an embodiment the cartridge comprises a cleaning pad 46. The pad 46 is located on and/or moved by the cover 48 for wiping the information plane and/or the interface surface when the cover is moved. Alternatively the pad or other cleaning units such as a brush may be placed on the cartridge itself. In an embodiment the cartridge is provided with a dust attracting inner layer for attracting any dust particles that may have entered the closed cartridge in spite of the cover 48.

Figure 5 shows an array of electro-magnetic elements. The array has electro-magnetic elements 51 in a regular pattern of rows. The elements of a row are coupled by shared bit lines 53, while in columns the elements share word lines 52. The electro-magnetic elements shown have a multilayer stack. An electro-magnetic element 54 is shown having opposite magnetic states in layers of the multilayer stack for representing the configuration when measuring a bit location with a logic value 0. An electro-magnetic element 55 is shown having equal magnetic states in layers of the multilayer stack for representing the configuration when measuring a bit location with a logic value 1. The direction is detected in sensor elements having a multilayer or single layer stack by using a magneto-resistive effect, for example GMR, AMR or TMR. The TMR type sensor is preferred for resistance matching reasons for the sensor element. While the given examples use magnetoresistive elements with in-plane sensitivity it is also possible to use elements that are sensitive to perpendicular fields. For a description of sensors using these effects refer to "Magnetoresistive sensors and memory" by K.-M.H. Lenssen, as published in "Frontiers of Multifunctional Nanosystems", page 431-452, ISBN 1-4020-0560-1 (HB) or 1-4020-0561-X (PB).

In the array electro-magnetic elements may be read-only elements only having the parts needed for read-mode as described with Figure 6 for constituting a playback-only device. This has the advantage that no electronic circuitry is needed for generating write currents. For example the device is a player for music which does not need a record function. Alternatively the electro-magnetic elements may be read-write elements as described with Figure 7. This has the advantage that the user may change the values of the bit locations. In an embodiment the array has a combination of read-only and read-write elements. This has the advantage that specific data on the record carrier is protected against accidental change and/or tampering with malicious intends. For example such data may be used for digital rights management, e.g. storing keys for copy protection by the content owner.

In the storage system data are represented by magnetization directions occurring at a sensor element due to the bit location opposite the sensor on the information plane. In the sensor element the read-out is done by a resistance measurement which relies on a magnetoresistance (MR) phenomenon detected in a multilayer stack. Sensor elements can be based on the anisotropic magnetoresistance (AMR) effect in thin films. Since the amplitude of the AMR effect in thin films is typically less than 3%, the use of AMR requires sensitive electronics. The larger giant magnetoresistance effect (GMR) has a larger MR effect (5 à 15%), and therefore a higher output signal. The magnetic tunnel junctions use a large tunnel magnetoresistance (TMR) effect, and resistance changes up to ≈50% have been shown. Because of the strong dependence of the TMR effect on the bias voltage, the useable resistance change in practical applications is at present around 35%. In general, both GMR and TMR result in a low resistance if the magnetization directions in the multilayer stack are parallel and in a high resistance when the magnetizations are oriented antiparallel. In TMR multilayers the sense current has to be applied perpendicular to the layer planes (CPP) because the electrons have to tunnel through the barrier layer; in GMR devices the sense current usually flows in the plane of the layers (CIP), although a CPP configuration might provide a larger MR effect, but the resistance perpendicular to the planes of these all-metallic multilayers is very small. Nevertheless, using further miniaturization, sensors based on CPP and GMR are possible.

Figure 6 shows a sensor element in read mode. The sensor element has a bit line 61 of an electrically conductive material for guiding a read current 67 to a multilayer stack of layers of a free magnetic layer 62, a tunneling barrier 63, and a fixed magnetic layer 64. The stack is build on a further conductor 65 connected via a selection line 68 to a selection transistor 66. The selection transistor 66 couples said read current 67 to ground level for reading the respective bit cell when activated by a control voltage on its gate. The magnetization directions 69 present in the fixed magnetic layer 64 and the free magnetic layer 62 determine the resistance in the tunneling barrier 63, similar to the bit cell elements in an MRAM memory. The magnetization in the free magnetic layer is determined by the magnetic state of the material of the bit location opposite the sensor element as described above with Figure 2, when such material is within the near-field working distance indicated by arrow 60.

In an embodiment a number of sensor elements are read at the same time. The addressing of the bit cells is done by means of an array of crossing lines. The read-out method depends on the type of sensor. In the case of pseudo-spin valves a number of cells (*N*) can be connected in series in the word line, because the resistance of these completely metallic cells is relatively low. This provides the interesting advantage that only one switching element (usually a transistor) is needed per N cells. The associated disadvantage is that the relative resistance change is divided by N. The read-out is done by measuring the resistance of a word line (with the series of cells), while subsequently a small positive plus negative current pulse is applied to the desired bit line. The accompanying magnetic field pulses are between the switching fields of the two ferromagnetic layers; thus the layer with the higher switching field (the sensing layer) will remain unchanged, while the magnetization of the other layer will be set in a defined direction and then be reversed. From the sign of the resulting resistance change in the word line it can be seen whether a '0' or a '1' is stored in the cell at the crossing point the word and the bit line. In an embodiment spin valves with a fixed magnetization direction are used and the data is detected in the other, free magnetic layer. In this case the absolute resistance of the cell is measured. In an embodiment the resistance is measured differentially with respect to a reference cell. This cell is selected by means of a switching element (usually a transistor), which implies that in this case one transistor is required per cell. Besides sensors with one transistor per cell, alternatively sensors without transistors within the cell are considered. The zero-transistor per cell sensor elements in cross-point geometry provide a higher density, but have a somewhat longer read time.

Figure 7 shows a read/write element in write mode. The read-write element has the same components as the sensor element in read mode described above with reference to Figure 6, and in addition a write line 71 for conducting a relatively large write current for generating a first write field component 72. Via bit line 61 a second write current 73 is guided for generating a second write field component 74. The combined field generated by both write currents is strong enough to set the magnetic state in the bit location opposite the read/write element. Writing a certain bit location is equivalent to setting a magnetization in the desired direction, for example, magnetization to the left means '0' and magnetization to the right means '1'. By applying a current pulse to a bit line and a word line a magnetic field pulse is induced. Only the bit location of the information plane opposite the crossing point of both lines experiences the maximum magnetic field (i.e. the vectorial addition of the fields induced by both current pulses) and its magnetization is reversed; all other bit locations above the bit or word line are exposed to the lower field that is caused by a single current pulse and will therefore not change their magnetization directions.

The storage system according to the invention is in particular suitable for the following applications. A first application is a portable device that needs removable memory, e.g. a laptop computer or portable music player. The storage device has low power consumption, and instant access to the data. The record carrier can also be used as a storage medium for content distribution. A further application is a memory that is copyright-protected. In contrast to existing solutions it has all the following properties: easily replicable, copy-protected, instant-on, fast access time, robust, no moving parts, low power consumption.

Although the invention has been mainly explained by embodiments using the TMR effect, any suitable read/write element for cooperating with the magnetic material can be used, e.g. based on coils. It is noted, that in this document the verb 'comprise' and its conjugations do not exclude the presence of other elements or steps than those listed and the word 'a' or 'an' preceding an element does not exclude the presence of a plurality of such elements, that any reference signs do not limit the scope of the claims, that the invention may be implemented by means of both hardware and software, and that several 'means' or 'units' may be represented by the same item of hardware or software. Further, the scope of the invention is not limited to the embodiments, and is defined by the appended claims.

## Claims

1. Storage system comprising a record carrier (40) and a storage device (35),
- the record carrier (40) having an information plane that is provided with an electro-magnetic material constituting a two-dimensional array of bit locations (11), a magnetic state of said material at a bit location representing the value thereof, and
- the storage device (35) having an interface surface (32) for cooperating with the information plane, which interface surface (32) is provided with a two-dimensional array of electro-magnetic elements (24, 25, 26) that are sensitive to said magnetic state of the electro-magnetic material,
which record carrier (40) can be coupled to and removed from the storage device (35),
**characterized in that** the record carrier (40) and the storage device (35) have complementary alignment elements (38, 41) for mechanically cooperating during said coupling for positioning the bit locations (11) in at least one aligned position with respect to the two-dimensional array of electro-magnetic elements (24, 25, 26), within a near-field working distance between a bit location and the corresponding electro-magnetic element.

2. Record carrier (40) for use in the system as claimed in claim 1, the record carrier (40) comprising an information plane on a substrate (21) that is provided with a layer (22) of an electro-magnetic material constituting a two-dimensional array of bit locations (11), a magnetic state of said material at a bit location representing the value thereof,
**characterized in that** the record carrier (40) comprises alignment elements (41) for mechanically cooperating during said coupling with complementary alignment elements (38) of the storage device (35) for positioning the two-dimensional array of bit locations (11) in at least one aligned position with respect to the two-dimensional array of electro-magnetic elements (24, 25, 26), within a near-field working distance between a bit location and the corresponding electro-magnetic element.

3. Record carrier (40) as claimed in claim 2, wherein the substrate (21) is of a flexible material for allowing positioning of the bit locations (11) near the electro-magnetic elements (24, 25, 26) within the near-field working distance between a bit location and the corresponding electro-magnetic element.

4. Record carrier (40) as claimed in claim 2, wherein the record carrier (40) comprises a cartridge (47) having an opening for exposing the information plane when coupled to the device and a cover (48) for closing the opening when removed from the device.

5. Record carrier (40) as claimed in claim 4, wherein the cartridge (47) comprises cleaning means (46) for cleaning the information plane and/or the interface surface (32).

6. Record carrier (40) as claimed in claim 2, wherein the alignment means (41) comprise mechanical guiding elements for cooperating with complementary mechanical receiving elements of the storage device (35).

7. Storage device (35) for use in the system as claimed in claim 1, the device comprising
- an interface surface (32) for cooperating with the information plane, which interface surface (32) is provided with a two-dimensional array of electro-magnetic elements (24, 25, 26) that are sensitive to said magnetic state of the electro-magnetic material, and
**characterized in that** the storage device (35) comprises alignment means comprising alignment elements (38) for mechanically cooperating during said coupling with complementary alignment elements (41) of the record carrier (40) for positioning the two-dimensional array of electro-magnetic elements (24, 25, 26) in at least one aligned position with respect to the two-dimensional array of bit locations (11), within a near-field working distance between an electro-magnetic element and the corresponding bit location.

8. Device (35) as claimed in claim 7, wherein the alignment means comprise an actuator for positioning the electro-magnetic elements (24, 25, 26) and/or the record carrier (40).

9. Device (35) as claimed in claim 8, wherein the actuator for positioning the electro-magnetic elements (24, 25, 26) and/or the record carrier (40) is controlled in dependence of a read-out signal from the electro-magnetic elements (24, 25, 26).

10. Device (35) as claimed in claim 7, wherein the array of electro-magnetic elements (31) has substantially less electro-magnetic elements then the array (11) of bit locations of the record carrier (40), and the alignment means (42, 44) are arranged for positioning said array or the record carrier (40) at different alignment positions that in combination cover the total number of bit locations.

11. Device (35) as claimed in claim 7, wherein the alignment means (38) comprise mechanical receiving elements for cooperating with complementary mechanical guiding elements (41) of the record carrier (40).

12. Device (35) as claimed in claim 7, wherein the alignment means comprise means for generating an attracting field for attracting the record carrier (40), in particular an electrostatic field.

## Patentansprüche

1. Speichersystem, das einen Datenträger (40) und einen Speicher (35) umfasst,
- wobei der Datenträger (40) eine Informationsebene hat, die mit einem elektromagnetischen Material versehen ist, das ein zweidimensionales Array von Bitpositionen (11) bildet, wobei ein Magnetisierungszustand des Materials an einer Bitposition den Wert davon darstellt, und
- der Speicher (35) eine Schnittstellenfläche (32) zum Zusammenwirken mit der Informationsebene hat, wobei die Schnittstellenfläche (32) mit einem zweidimensionalen Array von elektromagnetischen Elementen (24, 25, 26) versehen ist, die für den Magnetisierungszustand des elektromagnetischen Materials empfindlich sind, wobei der Datenträger (40) an den Speicher (35) gekoppelt und davon entfernt werden kann,
**dadurch gekennzeichnet, dass** der Datenträger (40) und der Speicher (35) komplementäre Ausrichtungselemente (38, 41) zum mechanischen Zusammenwirken während des Koppelns zum-Positionieren der Bitpositionen (11) in mindestens einer ausgerichteten Position in Bezug auf das zweidimensionale Array von elektromagnetischen Elementen (24, 25, 26) innerhalb eines Nahfeld-Arbeitsabstands zwischen einer Bitposition und dem entsprechenden elektromagnetischen Element haben.

2. Datenträger (40) zur Verwendung im System nach Anspruch 1, wobei der Datenträger (40) eine Informationsebene auf einem Substrat (21) umfasst, die mit einer Schicht (22) aus einem elektromagnetischen Material versehen ist, das ein zweidimensionales Array von Bitpositionen (11) bildet, wobei ein Magnetisierungszustand des Materials an einer Bitposition den Wert davon darstellt,
**dadurch gekennzeichnet, dass** der Datenträger (40) Ausrichtungselemente (41) umfasst, um während des Koppelns mit komplementären Ausrichtungselementen (38) des Speichers (35) zum Positionieren des zweidimensionalen Arrays von Bitpositionen (11) in mindestens einer ausgerichteten Position in Bezug auf das zweidimensionale Array von elektromagnetischen Elementen (24, 25, 26) innerhalb eines Nahfeld-Arbeitsabstands zwischen einer Bitposition und dem entsprechenden elektromagnetischen Element mechanisch zusammenzuwirken.

3. Datenträger (40) nach Anspruch 2, wobei das Substrat (21) zum Ermöglichen des Positionierens der Bitpositionen (11) in der Nähe der elektromagnetischen Elemente (24, 25, 26) innerhalb des Nahfeld-Arbeitsabstands zwischen einer Bitposition und dem entsprechenden elektromagnetischen Element aus einem biegsamen Material ist.

4. Datenträger (40) nach Anspruch 2, wobei der Datenträger (40) eine Cartridge (47) umfasst, die eine Öffnung zum Freilegen der Informationsebene, wenn sie mit der Vorrichtung gekoppelt ist, und eine Abdeckung (48) zum Schließen der Öffnung, wenn sie von der Vorrichtung entfernt wird, hat.

5. Datenträger (40) nach Anspruch 4, wobei die Cartridge (47) Reinigungsmittel (46) zum Reinigen der Informationsebene und/oder der Schnittstellenfläche (32) umfasst.

6. Datenträger (40) nach Anspruch 2, wobei die Ausrichtungsmittel (41) mechanische Führungselemente zum Zusammenwirken mit komplementären mechanischen Empfangselementen des Speichers (35) umfassen.

7. Speichervorrichtung (35) zur Verwendung im System nach Anspruch 1, wobei die Vorrichtung Folgendes umfasst:
- eine Schnittstellenfläche (32) zum Zusammenwirken mit der Informationsebene, wobei die Schnittstellenfläche (32) mit einem zweidimensionalen Array von elektromagnetischen Elementen (24, 25, 26) versehen ist, die empfindlich für den Magnetisierungszustand des elektromagnetischen Materials sind, und
**dadurch gekennzeichnet, dass** der Speicher (35) Ausrichtungsmittel umfasst, die Ausrichtungselemente (38) umfassen, um während des Koppelns mit komplementären Ausrichtungselementen (41) des Datenträgers (40) zum Positionieren des zweidimensionalen Arrays von elektromagnetischen Elementen (24, 25, 26) in mindestens einer ausgerichteten Position in Bezug auf das zweidimensionale Array von Bitpositionen (11) innerhalb eines Nahfeld-Arbeitsabstands zwischen einem elektromagnetischen Element und der entsprechenden Bitposition mechanisch zusammenzuwirken.

8. Vorrichtung (35) nach Anspruch 7, wobei die Ausrichtungsmittel ein Stellglied zum Positionieren der elektromagnetischen Elemente (24, 24, 26) und/oder des Datenträgers (40) umfassen.

9. Vorrichtung (35) nach Anspruch 8, wobei das Stellglied zum Positionieren der elektromagnetischen Elemente (24, 25, 26) und/oder des Datenträgers (40) in Abhängigkeit von einem Auslesesignal von den elektromagnetischen Elementen (24, 25, 26) gesteuert wird.

10. Vorrichtung (35) nach Anspruch 7, wobei das Array von elektromagnetischen Elementen (31) im Wesentlichen weniger elektromagnetische Elemente hat als das Array (11) von Bitpositionen des Datenträgers (40), und dass die Ausrichtungsmittel (42, 44) zum Positionieren des Arrays oder des Datenträgers (40) an unterschiedlichen Ausrichtungspositionen eingerichtet sind, die kombiniert die gesamte Anzahl von Bitpositionen abdecken.

11. Vorrichtung (35) nach Anspruch 7, wobei die Ausrichtungsmittel (38) mechanische Empfangselemente zum Zusammenwirken mit komplementären mechanischen Führungselementen (41) des Datenträgers (40) umfassen.

12. Vorrichtung (35) nach Anspruch 7, wobei die Ausrichtungsmittel Mittel zum Erzeugen eines Anziehungsfelds zum Anziehen des Datenträgers (40), insbesondere eines elektrostatischen Felds, umfassen.

## Revendications

1. Système de stockage comprenant un support d'enregistrement (40) et un dispositif de stockage (35),
- le support d'enregistrement (40) ayant un plan d'information qui comprend un matériau électromagnétique constituant une matrice bidimensionnelle d'emplacements de bits (11), un état magnétique dudit matériau à un emplacement de bit représentant sa valeur, et
- le dispositif de stockage (35) ayant une surface d'interface (32) pour coopérer avec le plan d'information, cette surface d'interface (32) possédant une matrice bidimensionnelle d'éléments électromagnétiques (24, 25, 26) qui sont sensibles audit état magnétique du matériau électromagnétique,
lequel support d'enregistrement (40) peut être couplé au dispositif de stockage (35) et enlevé de celui-ci,
**caractérisé en ce que** le support d'enregistrement (40) et le dispositif de stockage (35) ont des éléments d'alignement complémentaires (38, 41) pour coopérer mécaniquement pendant ledit couplage pour positionner les emplacements de bits (11) dans au moins une position alignée par rapport à la matrice bidimensionnelle d'éléments électromagnétiques (24, 25, 26), dans les limites d'une distance utile de champ proche entre un emplacement de bit et l'élément électromagnétique correspondant.

2. Support d'enregistrement (40) pour utilisation dans le système selon la revendication 1, le support d'enregistrement (40) comprenant un plan d'information sur un substrat (21) qui comprend une couche (22) d'un matériau électromagnétique constituant une matrice bidimensionnelle d'emplacements de bits (11), un état magnétique dudit matériau à un emplacement de bits représentant sa valeur,
**caractérisé en ce que** le support d'enregistrement (40) comprend des éléments d'alignement (41) pour coopérer mécaniquement pendant ledit couplage avec des éléments d'alignement complémentaires (38) du dispositif de stockage (35) pour positionner la matrice bidimensionnelle d'emplacements de bits (11) dans au moins une position alignée par rapport à la matrice bidimensionnelle d'éléments électromagnétiques (24, 25, 26), dans les limites d'une distance utile de champ proche entre un emplacement de bit et l'élément électromagnétique correspondant.

3. Support d'enregistrement (40) selon la revendication 2, dans lequel le substrat (21) est en matériau flexible pour permettre un positionnement des emplacements de bits (11) près des éléments électromagnétiques (24, 25, 26) dans les limites de la distance utile de champ proche entre un emplacement de bit et l'élément électromagnétique correspondant.

4. Support d'enregistrement (40) selon la revendication 2, dans lequel le support d'enregistrement (40) comprend une cartouche (47) ayant une ouverture pour exposer le plan d'information pendant le couplage du dispositif et un couvercle (48) pour fermer l'ouverture lorsqu'il est enlevé du dispositif.

5. Support d'enregistrement (40) selon la revendication 4, dans lequel la cartouche (47) comprend des moyens de nettoyage (46) pour nettoyer le plan d'information et/ou la surface interface (32).

6. Support d'enregistrement (40) selon la revendication 2, dans lequel les moyens d'alignement (41) comprennent des éléments de guidage mécanique pour coopérer avec des éléments récepteurs mécaniques complémentaires du dispositif de stockage (35).

7. Dispositif de stockage (35) pour utilisation dans le système selon la revendication 1, le dispositif comprenant
- une surface d'interface (32) pour coopérer avec le plan d'information, laquelle surface d'interface (32) comprend une matrice bidimensionnelle d'éléments électromagnétiques (24, 25, 26) qui sont sensibles audit état magnétique du matériau électromagnétique, et
**caractérisé en ce que** le dispositif de stockage (35) comprend des moyens d'alignement comprenant des éléments d'alignement (38) pour coopérer mécaniquement pendant ledit couplage avec des éléments d'alignement complémentaires (41) du support d'enregistrement (40) pour positionner la matrice bidimensionnelle d'éléments électromagnétiques (24, 25, 26) dans au moins une position alignée par rapport à la matrice bidimensionnelle d'emplacements de bits (11), dans les limites d'une distance utile de champ proche entre un élément électromagnétique et l'emplacement de bit correspondant.

8. Dispositif (35) selon la revendication 7, dans lequel les moyens d'alignement comprennent un actionneur pour positionner les éléments électromagnétiques (24, 25, 26) et/ou le support d'enregistrement (40).

9. Dispositif (35) selon la revendication 8, dans lequel l'actionneur de positionnement des éléments électromagnétiques (24, 25, 26) et/ou du support d'enregistrement (40) est commandé en fonction d'un signal de lecture à partir des éléments électromagnétiques (24, 25, 26).

10. Dispositif (35) selon la revendication 7, dans lequel la matrice d'éléments électromagnétiques (31) a substantiellement moins d'éléments électromagnétiques que la matrice (11) d'emplacements de bits du support d'enregistrement (40), et les moyens d'alignement (42, 44) sont aménagés pour positionner ladite matrice ou le support d'enregistrement (40) à des positions d'alignement différentes qui, combinées, couvrent le nombre total d'emplacements de bits.

11. Dispositif (35) selon la revendication 7, dans lequel les moyens d'alignement (38) comprennent des éléments récepteurs mécaniques pour coopérer avec les éléments de guidage mécanique complémentaires (41) du support d'enregistrement (40).

12. Dispositif (35) selon la revendication 7, dans lequel les moyens d'alignement comprennent des moyens pour générer un champ d'attraction pour attirer le support d'enregistrement (40), en particulier un champ électrostatique.
